# EUROPEAN PATENT APPLICATION

(11) **EP 4 607 163 A1**
(43) Date of publication of application: **27.08.2025**
(21) Application number: 24802150.3
(22) Date of filing: 17.10.2024
(51) Int. Cl.: G01J 5/48

(54) **TURNOUT HEATING MONITORING METHOD AND SYSTEM, STORAGE MEDIUM, AND ELECTRONIC DEVICE**

(30) Priority: 05.01.2024 CN 202410021227
(71) Applicant: CRSC RESEARCH & DESIGN INSTITUTE GROUP CO., LTD., Fengtai District Beijing 100070 (CN)
(72) Inventor: LI, Hui, Beijing 100070 (CN); ZHAO, Qiang, Beijing 100070 (CN); LI, Zhongming, Beijing 100070 (CN); CHEN, Guangyuan, Beijing 100070 (CN); ZHANG, Kaizhi, Beijing 100070 (CN); YANG, Xiaofeng, Beijing 100070 (CN); LIU, Jingwei, Beijing 100070 (CN); ZHOU, Zijian, Beijing 100070 (CN); LI, Xiayang, Beijing 100070 (CN); ZHOU, Tao, Beijing 100070 (CN); ZHANG, Da, Beijing 100070 (CN); CHEN, Junzhou, Beijing 100070 (CN)
(74) Representative: Haseltine Lake Kempner LLP
(86) International application number: PCT/CN2024/125396
(87) International publication number: WO 2025/145730

(57) **Abstract**

The present invention provides a turnout snow melting monitoring method, system, computer-readable storage medium and electronic device, relating to the technical field of snow melting of turnout. The method comprises: starting a heating device to heat a turnout; acquiring infrared images of the turnout; determining a temperature of the turnout based on the infrared images; confirming that the heating device is faulty if the temperature of the turnout is lower than a temperature threshold. Determining the temperature of the turnout from the taken infrared images of the turnout and comparing it with a temperature threshold value. When the temperature of the turnout as determined from the infrared image is lower than the temperature threshold value, it means that the temperature of the turnout does not reach the standard and the turnout fails to receive sufficient heat from the heating device, thereby concluding that the heating device is out of order.

## Description

### TECHNICAL FIELD

The present invention relates to the technical field of turnout snow melting, and in particular to turnout snow melting monitoring method, system, computer-readable storage medium, and electronic device.

### BACKGROUND

In the existing turnout snow melting monitoring system, the operating state of an electric heating element is determined by collecting the total current of the electric heating element. When a low-power electric heating element fails, it has little influence on the total current, so the system may not be able to accurately identify whether the electric heating element is faulty. Furthermore, when an alarm of the electric heating element occurs, it is necessary for maintenance personnel to detect all the electric heating elements to determine the faulty elements, and at least two people need to cooperate to check, which increases labor costs and has low maintenance efficiency.

In another turnout snow melting monitoring system, the operating state of the electric heating element is determined by collectors collecting the current, voltage, resistance, insulation status, and so on of the electric heating element. This method is only limited to systems that use electric heating elements for snow melting, and it is not possible to accurately monitor the specific faulty electric heating element. In order to accurately monitor the faulty electric heating elements, it is necessary to connect each electric heating element to a collector, so as to accurately determine which electric heating element is faulty. However, this method also needs to number the positions of the electric heating element and the collector, so as to accurately find the faulty electric heating elements, and the processing process is cumbersome, and setting multiple collectors will increase the cost.

### SUMMARY

In view of the above problems, the present invention provides a turnout snow melting monitoring method, system, computer-readable storage medium and electronic device, that can install infrared thermal imaging detectors around the turnouts without changing the existing monitoring nodes, thus realizing accurate and real-time monitoring of the operating status of the heating device and reducing the cost.

In a first aspect, a turnout heating monitoring method is provided, the method comprising:
starting a heating device to heat a turnout;
acquiring infrared images of the turnout;
determining a temperature of the turnout based on the infrared images;
confirming that the heating device is faulty if the temperature of the turnout is lower than a temperature threshold.

Further, the determining the temperature of the turnout based on the infrared images comprising:
acquiring RGB values of the infrared images;
determining the temperature of the turnout based on the RGB values.

Further, the acquiring RGB values of the infrared images comprising:
acquiring RGB values of a plurality of pixels in the same infrared image;
determining average values of the RGB values of the plurality of pixels as the RGB values of the infrared images.

Further, the plurality of pixels are uniformly distributed in the same infrared image.

Further, the method comprising:
determining the average temperature of a plurality of acquired infrared images as the temperature threshold.

Further, the method also includes:
outputting an alarm message if the heating device fails.

In a second aspect, there is provided a turnout heating monitoring system comprising:
a heating module, used to heat a turnout;
an acquisition module, used to acquire infrared images of the turnout;
a processing module, used to determine a temperature of the turnout based on the infrared images and confirm that the heating device is faulty if the temperature of the turnout is lower than a temperature threshold.

Further, the system also comprising:
an alarm module, used to output an alarm message if the heating module fails.

In a third aspect, a computer-readable storage medium, having a program or an instruction stored thereon, which when executed on a computer, causes the computer to implement the turnout heating monitoring method of any one of the above solutions.

In a fourth aspect, there is provided an electronic device, comprising: a processor, coupled to a memory,
the processor is used to read and execute a computer program stored in the memory to implement the turnout heating monitoring method of any one of the above solutions.

One or more technical solutions provided by the present application have at least the following technical effects or advantages:
Determining the temperature of the turnout from the infrared images taken of the turnout and comparing it with a temperature threshold value. When the temperature of the turnout as determined from the infrared image is lower than the temperature threshold value, it means that the temperature of the turnout does not reach the standard and the turnout fails to receive sufficient heat from the heating device, thereby concluding that the heating device is out of order. With this method, the operating condition of the heating device can be monitored remotely and in real time, and the specific position of the faulty heating device can be accurately determined through the position where the temperature does not reach the standard in the image, which enables the maintenance personnel to repair or replace the faulty heating device timely and accurately, reduces the time for the maintenance personnel to find the faulty heating device, improves the maintenance efficiency, and reduces the manpower cost.

Additional features and advantages of the present invention will be set forth in the following description, and in part will be obvious from the description, or may be learned by implementing the present invention. The objectives and other advantages of the present invention may be realized and obtained by the structure pointed out in the description and claims as well as the drawings.

### BRIEF DESCRIPTION OF THE DRAWINGS

In order to illustrate the embodiments of the present invention or the technical solution in the prior art more clearly, the drawings needed to be used in the description of the embodiments or the prior art will be briefly introduced below. Obviously, the drawings in the following description are some embodiments of the present invention, and other drawings can be obtained according to these drawings without creative work for those ordinary skilled in the art.
FIG. 1 is a schematic flow chart of a turnout heating monitoring method provided by an embodiment of the present invention;
FIG. 2 is a schematic structural diagram of a turnout heating monitoring system provided by an embodiment of the present invention;
FIG. 3 is a schematic structural diagram of another turnout heating monitoring system provided by an embodiment of the present invention.

### DETAILED DESCRIPTION

In order to make the purpose, technical solutions and advantages of the embodiments of the present invention clearer, the technical solutions of the embodiments of the present invention will be clearly and completely described below combined with the drawings of the embodiments of the present invention. Obviously, the described embodiment is a part of the embodiments of the present invention, not all of the embodiments. Based on the embodiments of the present invention, all other embodiments obtained by those ordinary skilled in the art without creative efforts are within the scope of protection of the present invention.

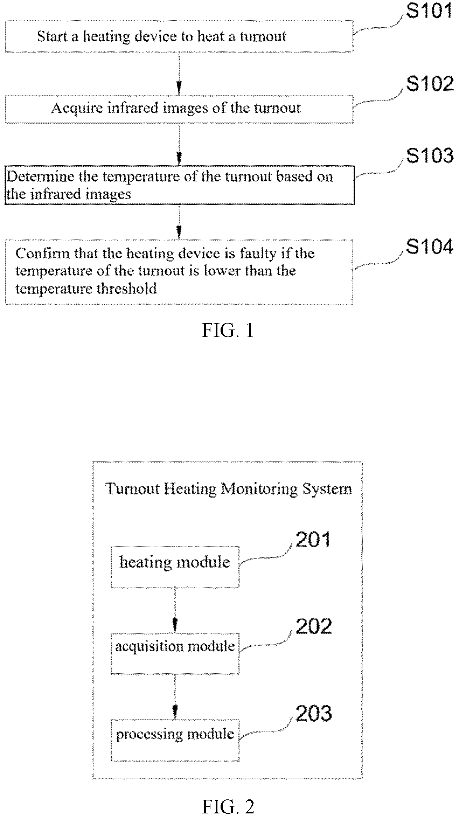

FIG. 1 is a schematic flow chart of a turnout heating monitoring method provided by an embodiment of the present invention. As shown in FIG. 1, the turnout heating monitoring method of the embodiment of the present invention specifically comprises the following steps:
S101: Start a heating device to heat a turnout.

Each side of the turnout includes a switch rail and a point rail, which are connected in turn, and heating devices are installed on the sides of the switch rail and the point rail. The heating devices can be installed on the sides of the switch rail and the point rail using existing mounting devices.

There are a plurality of heating devices installed on the side of the turnout. Generally, heating devices are installed about 2m from the initial position of the switch rail, four heating devices are installed at intervals of 4.7m, 4.7m, 4.7m, 3.72m, and two heating devices are installed at intervals at positions of 4.7m and 3.72m of the point rail. Six heating devices are installed on each side of the turnout, and a total of twelve heating devices are installed.

The above is only an example to illustrate the installation position and the number of heating devices. In practical application, the installation number and spacing of heating devices may also be different depending on the types of turnouts.

The heating device will generate heat energy when working and transfer the heat energy to the turnout by heat radiation and heat conduction, so as to heat the turnout and evaporate the snow and ice above the turnout, thus achieve the purpose of snow removal and deicing.

In this embodiment, the heating device is an electric heating device. After the electric heating device is electrified, it can convert electric energy into heat energy and transfer it outward.

S102: Acquire infrared images of the turnout.

Infrared image is the abbreviation of thermal infrared image, also called thermal image. The infrared image is the image that is formed by infrared thermal imaging detector receiving and recording the thermal radiant energy emitted by the target object. The thermal infrared image is thermal radiation imaging, which came into being with infrared imaging technology. Infrared imaging technology is a thermal radiation information detection technology, which images according to the infrared radiation difference of the object. Infrared thermal imaging system can transform the natural radiation distribution of the object surface into visible image. Since different objects or different parts of the same object usually have different thermal radiation characteristics, such as temperature difference, emissivity, etc., after thermal infrared imaging, objects in the thermal infrared images are distinguished due to their differences in thermal radiation. The acquisition of thermal infrared images is independent of external light, and it has the characteristics of all-weather.

Specifically, infrared thermal imaging detectors are installed around the turnout, and infrared images of the turnout are taken by the infrared thermal imaging detectors. This can be achieved by fixing the column on the ground around the turnout, installing a rotating bracket on the column, and installing the infrared thermal imaging detector on the rotating bracket. Here is only an example of installing infrared thermal imaging detector. In practical application, technicians can design other more reasonable structures for installing infrared thermal imaging detector according to the actual surrounding environment and location.

Specifically, an infrared image of the switch rail and the point rail on both sides of the turnout can be taken respectively, and a total of four images are taken.

S103: Determine the temperature of the turnout based on the infrared images.

A total of four infrared images are taken for a group of turnouts. During the monitoring, the four infrared images can be monitored simultaneously or one by one, depending on the operating capabilities of the device.

Step S103 specifically includes the following steps:
S1031: Acquire RGB values of the infrared images.

RGB color mode is a color standard in industry. It obtains various colors by changing the three color channels of red (R), green (G) and blue (B) and superimposing them. RGB is the color representing the three channels of red, green and blue. This standard includes almost all colors that human vision can perceive, and it is one of the most widely used color systems. All the colors on the computer screen are made up of red, green, and blue lights in different proportions. A set of red, green, and blue is the smallest display unit. Any color on the screen can be recorded and expressed by a set of RGB values.

Select one of the four infrared images of the turnout captured by the infrared thermal imaging detector, randomly select a pixel point from the selected infrared image and determine the RGB value of the pixel point based on the selected pixel point.

As another possible implementation, multiple pixels can be selected from the selected infrared image, which can be three pixels or four pixels, etc., and the RGB value of each selected pixel is determined. After calculating the RGB average value of the selected multiple pixels, this RGB average value is used to represent the RGB value of the acquired infrared image.

In order to more accurately reflect the RGB values of the acquired infrared image when selecting multiple pixels to calculate the RGB average values, multiple pixels are selected at intervals when selecting multiple pixels. Preferably, the selected multiple pixels are uniformly distributed in the same infrared image, and multiple pixels are distributed at equal intervals.

S 1032: Determine the temperature of the turnout based on the RGB values.

The RGB values of a selected pixel or the RGB average values of multiple selected pixels, find the temperature value represented by the RGB value of this pixel in the RGB value and temperature comparison table, and the determined temperature is the temperature of the turnout.

S104: Confirm that the heating device is faulty if the temperature of the turnout is lower than the temperature threshold.

When determining the temperature threshold, at least two of the four infrared images taken can be selected, and the average temperature of the selected at least two infrared images can be obtained, and the average temperature is used as the temperature threshold. In order to confirm the accuracy of the threshold, when selecting infrared images, more images, for example, three or four images, can be selected.

Since the heating device converts electrical energy into thermal energy and transfers it to the turnout, causing the temperature of the turnout to rise. When the temperature of the turnout detected by the heating device is lower than the temperature threshold value, it means that the temperature of the turnout is insufficient and sufficient thermal energy is not received from the heating device, thereby concluding that the heating device has failed.

When the temperature of the turnout is higher than the temperature threshold, confirming that the heating device is heating the turnout normally and that the heating device is not faulty. Then, the infrared thermal imaging detector can continue to reacquire another infrared image of the next period and repeat the above steps to achieve real-time monitoring of the operating status of the heating device.

According to an embodiment of the present invention, optionally, step S104 may further include outputting alarm information if the heating device fails.

When it is confirmed that the heating device is faulty, an alarm message is issued to prompt maintenance personnel to repair or replace the faulty heating device as soon as possible.

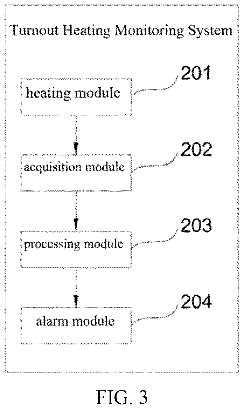

FIG. 2 is a schematic structural diagram of a turnout heating monitoring system provided by an embodiment of the present invention. FIG. 3 is a schematic structural diagram of another turnout heating monitoring system provided by an embodiment of the present invention. The embodiment of the present invention also provides a turnout heating monitoring system, as shown in FIG. 2, the system comprises:
A heating module 201, which is used to heat the turnout;
An acquisition module 202, which is used to acquire infrared images of the turnout;
A processing module 203, which is used to determine the temperature of the turnout based on the infrared image and confirm that the heating device is faulty if the temperature of the turnout is lower than a temperature threshold.

As shown in FIG. 3, as another possible implementation, the system further comprises:
An alarm module 204, which is used to output alarm information when the heating module 201 fails.

The above technical solutions in the embodiments of the present application have at least the following technical effects or advantages:
Determining the temperature of the turnout from the infrared images taken of the turnout and comparing it with a temperature threshold value. When the temperature of the turnout as determined from the infrared image is lower than the temperature threshold value, it means that the temperature of the turnout does not reach the standard and the turnout fails to receive sufficient heat from the heating device, thereby concluding that the heating device is out of order. With this method, the operating condition of the heating device can be monitored remotely and in real time, and the specific position of the faulty heating device can be accurately determined through the position where the temperature does not reach the standard in the image, which enables the maintenance personnel to repair or replace the faulty heating device timely and accurately, reduces the time for the maintenance personnel to find the faulty heating device, improves the maintenance efficiency, and reduces the manpower cost.

The embodiments of the present invention also provides a computer-readable storage medium that stores a program or instructions, which when executed on a computer, causes the computer to implement the turnout heating monitoring method of embodiment 1.

The embodiments of the present invention also provide an electronic device, comprising: a processor, coupled to a memory,
the processor, used to read and execute the computer program stored in the memory to implement the turnout heating monitoring method of the above method embodiment.

Although the present invention has been described in detail with reference to the foregoing embodiments, those ordinary skilled in the art should understand that they can modify the technical solutions described in the foregoing embodiments or substitute some of the technical features with equivalents. However, these modifications or substitutions do not cause the essence of the corresponding technical solution to deviate from the spirit and scope of the technical solution of the embodiments of the present invention.

## Claims

1. A turnout heating monitoring method, **characterized in that**, comprising:
starting a heating device to heat a turnout;
acquiring infrared images of the turnout;
determining a temperature of the turnout based on the infrared images;
confirming that the heating device is faulty if the temperature of the turnout is lower than a temperature threshold.

2. The method as claimed in claim 1, **characterized in that**, the determining the temperature of the turnout based on the infrared images comprising:
acquiring RGB values of the infrared images;
determining the temperature of the turnout based on the RGB values.

3. The method as claimed in claim 2, **characterized in that**, the acquiring RGB values of the infrared images comprising:
acquiring RGB values of a plurality of pixels in the same infrared image;
determining average values of the RGB values of the plurality of pixels as the RGB values of the infrared images.

4. The method as claimed in claim 3, **characterized in that**,
the plurality of pixels are uniformly distributed in the same infrared image.

5. The method as claimed in any one of claims 1 to 4, **characterized in that**, comprising:
determining the average temperature of a plurality of acquired infrared images as the temperature threshold.

6. The method as claimed in any one of claims 1 to 4, **characterized in that**, further comprising:
outputting an alarm message if the heating device fails.

7. A turnout heating monitoring system, **characterized in that**, comprising:
a heating module, used to heat a turnout;
an acquisition module, used to acquire infrared images of the turnout;
a processing module, used to determine a temperature of the turnout based on the infrared images and confirm that the heating device is faulty if the temperature of the turnout is lower than a temperature threshold.

8. The system as claimed in claim 7, **characterized in that**, further comprising:
an alarm module, used to output an alarm message if the heating module fails.

9. A computer-readable storage medium, **characterized in that**, having a program or an instruction stored thereon, which when executed on a computer, causes the computer to implement the turnout heating monitoring method of any one of claims 1-6.

10. An electronic device, **characterized in that**, comprising: a processor, coupled to a memory,
the processor is used to read and execute a computer program stored in the memory to implement the turnout heating monitoring method of any one of claims 1-6.
